# EUROPEAN PATENT APPLICATION

(11) **EP 4 644 331 A2**
(43) Date of publication of application: **05.11.2025**
(21) Application number: 25169290.1
(22) Date of filing: 08.04.2025
(51) Int. Cl.: C01G 53/00, H01M 4/131, H01M 4/36, H01M 4/525, H01M 4/58, H01M 10/0525, H01M 4/505, H01M 4/62

(54) **POSITIVE ELECTRODE AND RECHARGEABLE LITHIUM BATTERY INCLUDING THE SAME**

(30) Priority: 29.04.2024 KR 20240057135
(71) Applicant: SAMSUNG SDI CO., LTD., Yongin-si, Gyeonggi-do 17084 (KR)
(72) Inventor: KIM, Young-Ki, 17084 Yongin-si (KR); CHOI, Aram, 17084 Yongin-si (KR); KIM, Sangmi, 17084 Yongin-si (KR); DOO, Sungwook, 17084 Yongin-si (KR); KANG, Gwiwoon, 17084 Yongin-si (KR); LEE, Soonrewl, 17084 Yongin-si (KR)
(74) Representative: Marks & Clerk LLP

(57) **Abstract**

Examples of the disclosure include a positive electrode, and a rechargeable lithium battery including the positive electrode. Examples include a positive electrode for a rechargeable lithium battery including a current collector, a first active material layer on the current collector, and a second active material layer on the first active material layer. The first active material layer includes a first particle containing an olivine structured compound, a second particle containing a layered compound, a first conductive material, and a first binder. The second active material layer includes a third particle containing an olivine structured compound, a second conductive material, and a second binder.

## Description

### BACKGROUND

Examples of the present disclosure relate to a positive electrode, and a rechargeable lithium battery including the positive electrode, and in other examples, to a positive electrode including an olivine-based lithium compound, and a rechargeable lithium battery including the positive electrode.

The increased use of battery-powered electronics, such as mobile phones, laptop computers, electric vehicles, and the like, has driven a sharp rise in demand for rechargeable batteries provided with high energy density and high capacity. Accordingly, improving the performance of rechargeable lithium batteries may be advantageous.

Rechargeable lithium batteries typically include a positive electrode and a negative electrode, each of the positive electrode and the negative electrode including an active material that allows intercalation and deintercalation of lithium ions, and an electrolyte solution, and produce electrical energy from redox reactions that take place as lithium ions are intercalated into or deintercalated from the positive electrode and the negative electrode.

### SUMMARY

Examples of the present disclosure include a positive electrode allowing an electrode plate to be readily prepared by increasing bindability between a current collector and a positive electrode active material.

Examples of the present disclosure also include a positive electrode having improved capacity and lifetime characteristics.

An example embodiment of the present disclosure includes a positive electrode for a rechargeable lithium battery, the positive electrode including a current collector, a first active material layer on the current collector, and a second active material layer on the first active material layer. The first active material layer includes a first particle containing an olivine structured compound represented by Formula 1 below, a second particle containing a layered compound represented by Formula 2 below, a first conductive material, and a first binder. The second active material layer includes a third particle containing an olivine structured compound represented by Formula 3 below, a second conductive material, and a second binder. The first particle and the third particle are in the form of a single particle, the first binder and the first conductive material constitute a first functional additive, the second binder and the second conductive material constitute a second functional additive, and a ratio of a weight ratio of the second functional additive in the second active material layer to a weight ratio of the first functional additive in the first active material layer is in a range of about 1.0 to about 2.6,

Formula 1: Liₐ₁Feₓ₁B1_{y1}PO_{4-c1}

in Formula 1 above, 0.8<a1≤1.2, 0.95≤x1≤0.999, 0.001≤y1≤0.05, x1+y1=1, and 0≤c1≤0.05 are satisfied, and B1 is or includes at least one of Ti and a transition metal having an oxidation number of 4,

Formula 2: Liₐ₂Niₓ₂Co_{y2}B2_{z2}O_{2-c2}

in Formula 2 above, 0.8<a2≤1.2, 0.9≤x2≤1.05, 0.03≤y2≤0.10, 0.01≤z2≤0.05, and 0≤c2≤0.05 are satisfied, and B2 is or includes at least one of Al and Mn, and **[0011]**

Formula 3: Liₐ₃Feₓ₃B3_{y3}PO_{4-c3}

in Formula 3 above, 0.8<a3≤1.2, 0.95≤x3≤0.999, 0.001≤y3≤0.05, x3+y3=1, and 0≤c3≤0.05 are satisfied, and B3 is or includes at least one of Ti and a transition metal having an oxidation number of 4.

In an example embodiment of the present disclosure, a positive electrode for a rechargeable lithium battery includes a current collector, a first active material layer on the current collector, and a second active material layer on the first active material layer. The first active material layer includes a first particle containing an olivine structured compound represented by Formula 1 restated below, a second particle containing a layered compound represented by Formula 2 restated below, a first conductive material, and a first binder. The second active material layer includes a third particle containing an olivine structured compound represented by Formula 3 restated below, a second conductive material, and a second binder. The first particle and the third particle are in the form of a single particle, and the content of the first binder in the first active material layer is lower than the content of the second binder in the second active material layer,
Formula 1 (same as Formula 1 discussed above):

   Liₐ₁Feₓ₁B1_{y1}PO_{4-c1}

   in Formula 1 above, 0.8<a1≤1.2, 0.95≤x1≤0.999, 0.001≤y1≤0.05, x1+y1=1, and 0≤c1≤0.05 are satisfied, and B1 is or includes at least one of Ti and a transition metal having an oxidation number of 4,
Formula 2 (same as Formula 2 discussed above):

   Liₐ₂Niₓ₂Co_{y2}B2_{z2}O_{2-c2}

   in Formula 2 above, 0.8<a2≤1.2, 0.9≤x2≤1.05, 0.03≤y2≤0.10, 0.01≤z2≤0.05, and 0≤c2≤0.05 are satisfied, and B2 is or includes at least one of Al and Mn, and
Formula 3 (same as Formula 3 discussed above):

   Liₐ₃Feₓ₃B3_{y3}PO_{4-c3}

   in Formula 3 above, 0.8<a3≤1.2, 0.95≤x3≤0.999, 0.001≤y3≤0.05, x3+y3=1, and 0≤c3≤0.05 are satisfied, and B3 is or includes at least one of Ti and a transition metal having an oxidation number of 4.

In an example embodiment of the present disclosure, a rechargeable lithium battery includes the positive electrode described above.

At least some of the above and other features of the invention are set out in the claims.

### BRIEF DESCRIPTION OF THE FIGURES

The accompanying drawings are included to provide a further understanding of the present disclosure, and are incorporated in and constitute a part of this specification. The drawings illustrate example embodiments of the present disclosure and, together with the description, serve to explain principles of the present disclosure. In the drawings:
FIG. 1 is a simplified conceptual view showing a rechargeable lithium battery according to example embodiments of the present disclosure;
FIGS. 2 to 5 are schematic views illustrating a rechargeable lithium battery according to an example embodiment, where FIG. 2 illustrates a cylindrical battery, FIG. 3 illustrates a prismatic battery, and FIGS. 4 and 5 illustrate pouch-type batteries;
FIG. 6 is a cross-sectional view illustrating a positive electrode for a rechargeable battery according to example embodiments of the present disclosure;
FIG. 7 is an enlarged view illustrating a first active material layer according to example embodiments of the present disclosure;
FIG. 8 is an enlarged view illustrating a second active material layer according to example embodiments of the present disclosure;
FIG. 9 is an SEM image showing a first particle of Preparation Example 1 according to the present disclosure;
FIG. 10 is an SEM image showing a second particle (having the form of a single particle) of Preparation Example 2 according to the present disclosure;
FIG. 11 is an SEM image showing a second particle (having the form of a secondary particle) according to an example embodiment of the present disclosure; and
FIG. 12 is an SEM image showing a third particle of Preparation Example 3 according to the present disclosure.

### DETAILED DESCRIPTION

In order to sufficiently understand the configuration and effect of the present disclosure, some example embodiments of the present disclosure are described with reference to the accompanying drawings. It should be noted, however, that the present disclosure is not limited to the following example embodiments, and may be implemented in various forms. Rather, the example embodiments are provided only to disclose the present disclosure, and let those skilled in the art fully know the scope of the present disclosure.

In this description, it is understood that, when an element is referred to as being "on" another element, the element can be directly on the other element or intervening elements may be present between therebetween. In the drawings, thicknesses of some components may be exaggerated for effectively explaining the technical contents. Like reference numerals refer to like elements throughout the specification.

The example embodiments described herein are explained with reference to the cross-sectional views and/or plan views as ideal example views of the present disclosure. In the drawing, the thicknesses of films and regions may be exaggerated for effective description of the technical contents. Thus, regions presented as an example in the drawings have general properties, and shapes of the exemplified areas are used to illustrate a specific shape of a device region. Therefore, this should not be construed as limited to the scope of the present disclosure. Although the terms such as first, second, and third are used to describe various components in various example embodiments herein, the components should not be limited to these terms. These terms are used only to distinguish one component from another component. Example embodiments described and exemplified herein include complementary example embodiments thereof.

Unless otherwise specially noted in this description, the expression of singular form may include the expression of plural form. In addition, unless otherwise specially noted, the phrase "A or B" may indicate "A but not B", "B but not A", and "A and B". The terms "comprises/includes" and/or "comprising/including" used in this description do not exclude the presence or addition of one or more other components.

As used herein, the term "combination thereof" may refer to a mixture, a stack, a composite, a copolymer, an alloy, a blend, or a reaction product.

Unless otherwise especially defined in this description, a particle diameter may be an average particle diameter. In addition, a particle diameter indicates an average particle diameter (D50) where a cumulative volume is about 50 volume% in a particle size distribution. The average particle diameter (D50) may be measured by a method widely known to those skilled in the art, for example, by a particle size analyzer, a transmission electron microscope (TEM) image, or a scanning electron microscope (SEM) image. Alternatively, a dynamic light-scattering measurement device is used to perform a data analysis, the number of particles is counted for each particle size range, and from this, the average particle diameter (D50) value may be obtained through a calculation. Alternatively, a laser scattering method may be utilized to measure the average particle diameter (D50). In the laser scattering method, a target particle is distributed in a distribution solvent, introduced into a laser scattering particle-diameter measurement device (e.g., MT3000 commercially available from Microtrac, Inc), irradiated with ultrasonic waves of 28 kHz at a power of 60 W, and an average particle diameter (D50) is calculated in the 50% standard of particle diameter distribution in the measurement device.

When the terms "about" or "substantially" are used in this specification in connection with a numerical value, it is intended that the associated numerical value include a tolerance of ±10% around the stated numerical value. The expression "up to" includes amounts of zero to the expressed upper limit and all values therebetween. When ranges are specified, the range includes all values therebetween such as increments of 0.1%.

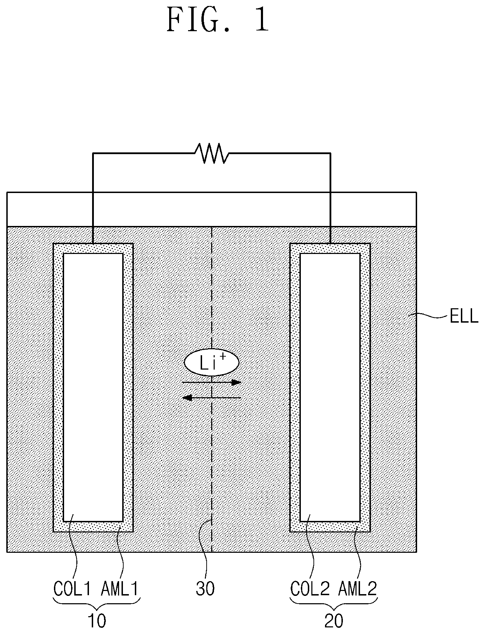

FIG. 1 is a cross-sectional view of a rechargeable lithium battery according to example embodiments of the present disclosure. Referring to FIG. 1, the rechargeable lithium battery may include a positive electrode 10, a negative electrode 20, a separator 30, and an electrolyte solution ELL.

The positive electrode 10 and the negative electrode 20 may be spaced apart from each other by the separator 30. The separator 30 may be located between the positive electrode 10 and the negative electrode 20. The positive electrode 10, the negative electrode 20 and the separator 30 may be in contact with the electrolyte solution ELL. The positive electrode 10, the negative electrode 20 and the separator 30 may be impregnated in the electrolyte solution ELL.

The electrolyte solution ELL may be or include a medium for transferring lithium ions between the positive electrode 10 and the negative electrode 20. In the electrolyte solution ELL, the lithium ions may move through the separator 30 toward the positive electrode 10 or the negative electrode 20.

### Positive Electrode 10

The positive electrode 10 for a rechargeable lithium battery includes a current collector COL1 and a positive electrode active material layer AML1 formed on the current collector COL1. The positive electrode active material layer AML1 includes a positive electrode active material, and further includes a binder and a conductive material.

For example, the positive electrode 10 may further include an additive that can constitute a sacrificial positive electrode.

Al may be included in or constitute the current collector COL1, but is not limited thereto.

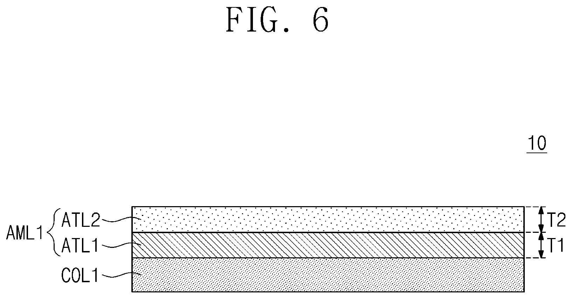

The positive electrode 10 according to example embodiments of the present disclosure is described in detail with reference to FIG. 6 below.

### Negative Electrode 20

The negative electrode 20 for a rechargeable lithium battery may include a current collector COL2 and a negative electrode active material layer AML2 on the current collector COL2. The negative electrode active material layer AML2 may include a negative electrode active material, and may further include a binder and/or a conductive material (e.g., an electrically conductive material).

For example, the negative electrode active material layer AML2 may include a range of about 90 wt% to about 99 wt% of the negative electrode active material, a range of about 0.5 wt% to about 5 wt% of the binder, and a range of about 0 wt% to about 5 wt% of the conductive material.

The binder may be configured to attach the negative electrode active material particles to each other, and also to attach the negative electrode active material to the current collector COL2. The binder may include a non-aqueous binder, an aqueous binder, a dry binder, or a combination thereof.

The non-aqueous binder may include at least one of polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, polyamideimide, polyimide, or a combination thereof.

The aqueous binder may be or include at least one of a styrene-butadiene rubber, a (meth)acrylated styrene-butadiene rubber, a (meth)acrylonitrile-butadiene rubber, (meth)acrylic rubber, a butyl rubber, a fluoro rubber, polyethylene oxide, polyvinylpyrrolidone, polyepichlorohydrin, polyphosphazene, poly(meth)acrylonitrile, an ethylene propylene diene copolymer, polyvinylpyridine, chlorosulfonated polyethylene, latex, a polyester resin, a (meth)acrylic resin, a phenol resin, an epoxy resins, polyvinyl alcohol, and a combination thereof.

When an aqueous binder is used as the negative electrode binder, a cellulose-based compound capable of imparting viscosity may be further included. The cellulose-based compound may include at least one of carboxymethyl cellulose, hydroxypropylmethyl cellulose, methyl cellulose, or an alkali metal salt thereof. The alkali metal may include at least one of Na, K, or Li.

The dry binder may be or include a polymer material that is capable of being fibrous. For example, the dry binder may be or include at least one of polytetrafluoroethylene, polyvinylidene fluoride, a polyvinylidene fluoride-hexafluoropropylene copolymer, polyethylene oxide, or a combination thereof.

The conductive material may be configured to impart conductivity (e.g., electrical conductivity) to the electrode. Any material that does not cause chemical change (e.g., does not cause an undesirable chemical change in the rechargeable lithium battery), and that conducts electrons, can be included in the battery. Non-limiting examples thereof may include a carbon-based material such as at least one of natural graphite, artificial graphite, carbon black, acetylene black, ketjen black, a carbon fiber, a carbon nanofiber, and a carbon nanotube; a metal-based material including at least one of copper, nickel, aluminium, silver, etc. in a form of a metal powder or a metal fiber; a conductive polymer such as a polyphenylene derivative; or a mixture thereof.

The negative current collector COL2 may include at least one of a copper foil, a nickel foil, a stainless steel foil, a titanium foil, a nickel foam, a copper foam, a polymer substrate coated with a conductive metal, or a combination thereof.

### Negative Electrode Active Material

The negative electrode active material may include at least one of a material that reversibly intercalates/deintercalates lithium ions, a lithium metal, a lithium metal alloy, a material capable of doping/dedoping lithium, or a transition metal oxide.

The material that reversibly intercalates/deintercalates lithium ions may include a carbon-based negative electrode active material, such as, for example. crystalline carbon, amorphous carbon or a combination thereof. The crystalline carbon may be graphite such as non-shaped, sheet-shaped, flake-shaped, sphere-shaped, or fiber-shaped natural graphite or artificial graphite. The amorphous carbon may be or include at least one of a soft carbon, a hard carbon, a mesophase pitch carbonization product, calcined coke, and the like.

The lithium metal alloy includes an alloy of lithium and a metal such as or including at least one of Na, K, Rb, Cs, Fr, Be, Mg, Ca, Sr, Si, Sb, Pb, In, Zn, Ba, Ra, Ge, Al, and Sn.

The material capable of doping/dedoping lithium may be or include a Si-based negative electrode active material or a Sn-based negative electrode active material. The Si-based negative electrode active material may include at least one of silicon, a silicon-carbon composite, SiOx (0 < x < 2), a Si-Q alloy (where Q is or includes at least one of an alkali metal, an alkaline-earth metal, a Group 13 element, a Group 14 element (excluding Si), a Group 15 element, a Group 16 element, a transition metal, a rare earth element, and a combination thereof). The Sn-based negative electrode active material may include at least one of Sn, SnO₂, a Sn-based alloy, or a combination thereof.

The silicon-carbon composite may be or include a composite of silicon and amorphous carbon. According to an example embodiment, the silicon-carbon composite may be in the form of silicon particles, and amorphous carbon coated on the surface of the silicon particles. For example, the silicon-carbon composite may include a secondary particle (core) in which primary silicon particles are assembled, and an amorphous carbon coating layer (shell) on the surface of the secondary particle. The amorphous carbon may also be between the primary silicon particles, and, for example, the primary silicon particles may be coated with the amorphous carbon. The secondary particle may be dispersed in an amorphous carbon matrix.

The silicon-carbon composite may further include crystalline carbon. For example, the silicon-carbon composite may include a core including crystalline carbon, and silicon particles and an amorphous carbon coating layer on a surface of the core.

The Si-based negative electrode active material or the Sn-based negative electrode active material may be combined with a carbon-based negative electrode active material.

### Separator 30

Depending on the type of the rechargeable lithium battery, the separator 30 may be between the positive electrode 10 and the negative electrode 20. The separator 30 may include at least one of polyethylene, polypropylene, polyvinylidene fluoride, or a multilayer film of two or more layers thereof, and a mixed multilayer film such as a polyethylene/polypropylene two-layer separator, polyethylene/polypropylene/polyethylene three-layer separator, polypropylene/polyethylene/polypropylene three-layer separator, and the like.

The separator 30 may include a porous substrate and a coating layer including an organic material, an inorganic material, or a combination thereof on one or both surfaces of the porous substrate.

The porous substrate may be or include a polymer film formed of any one of polyolefin such as polyethylene and polypropylene, polyester such as polyethylene terephthalate and polybutylene terephthalate, polyacetal, polyamide, polyimide, polycarbonate, polyether ketone, polyarylether ketone, polyetherimide, polyamideimide, polybenzimidazole, polyethersulfone, polyphenylene oxide, a cyclic olefin copolymer, polyphenylene sulfide, polyethylene naphthalate, a glass fiber, TEFLON, and polytetrafluoroethylene, or a copolymer or mixture of two or more thereof.

The organic material may include a polyvinylidene fluoride-based polymer or a (meth)acrylic polymer.

The inorganic material may include inorganic particles such as or including at least one of Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and a combination thereof, but is not limited thereto.

The organic material and the inorganic material may be mixed in one coating layer, or a coating layer including an organic material and a coating layer including an inorganic material may be stacked.

### Electrolyte Solution ELL

The electrolyte solution ELL for a rechargeable lithium battery may include a non-aqueous organic solvent and a lithium salt.

The non-aqueous organic solvent may constitute a medium for transmitting ions taking part in the electrochemical reaction of a battery.

The non-aqueous organic solvent may be or include at least one of a carbonate-based, ester-based, ether-based, ketone-based, or alcohol-based solvent, an aprotic solvent, or a combination thereof.

The carbonate-based solvent may include at least one of dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), and the like.

The ester-based solvent may include at least one of methyl acetate, ethyl acetate, n-propyl acetate, dimethyl acetate, methyl propionate, ethyl propionate, decanolide, mevalonolactone, valerolactone, caprolactone, and the like.

The ether-based solvent may include at least one of dibutyl ether, tetraglyme, diglyme, dimethoxyethane, 2-methyltetrahydrofuran, 2,5-dimethyltetrahydrofuran, tetrahydrofuran, and the like. In addition, the ketone-based solvent may include cyclohexanone, and the like. The alcohol-based solvent may include at least one of ethanol, isopropyl alcohol, and the like and the aprotic solvent may include at least one of nitriles such as R-CN (wherein R is a C2 to C20 linear, branched, or cyclic hydrocarbon group, a double bond, an aromatic ring, or an ether bond), and the like; amides such as dimethylformamide; dioxolanes such as 1,3-dioxolane, 1,4-dioxolane, and the like; sulfolanes, and the like.

The non-aqueous organic solvents may be used alone or in combination of two or more solvents.

In addition, when using a carbonate-based solvent, a cyclic carbonate and a chain carbonate may be mixed and used, and the cyclic carbonate and the chain carbonate may be mixed in a volume ratio in a range of about 1:1 to about 1:9.
The lithium salt dissolved in the organic solvent may supply lithium ions in a battery, may enable a basic operation of a rechargeable lithium battery, and may improve transportation of the lithium ions between positive and negative electrodes. Examples of the lithium salt include at least one of LiPF₆, LiBF₄, LiSbF₆, LiAsF₆, LiClO₄, LiAlO₂, LiAlCl₄, LiPO₂F₂, LiCl, LiI, LiN(SO₃C₂F₅)₂, Li(FSO₂)₂N (lithium bis(fluorosulfonyl)imide, LiFSI), LiC₄F₉SO₃, LiN(CₓF₂ₓ₊₁SO₂)(C_{y}F_{2y+1}SO₂) (wherein x and y are integers of 1 to 20), lithium trifluoromethane sulfonate, lithium tetrafluoroethanesulfonate, lithium difluoro(oxalato)borate (LiDFOB), lithium difluorobis(oxalato)phosphate (LiDFBOP), and lithium bis(oxalato)borate (LiBOB).

### Rechargeable Lithium Battery

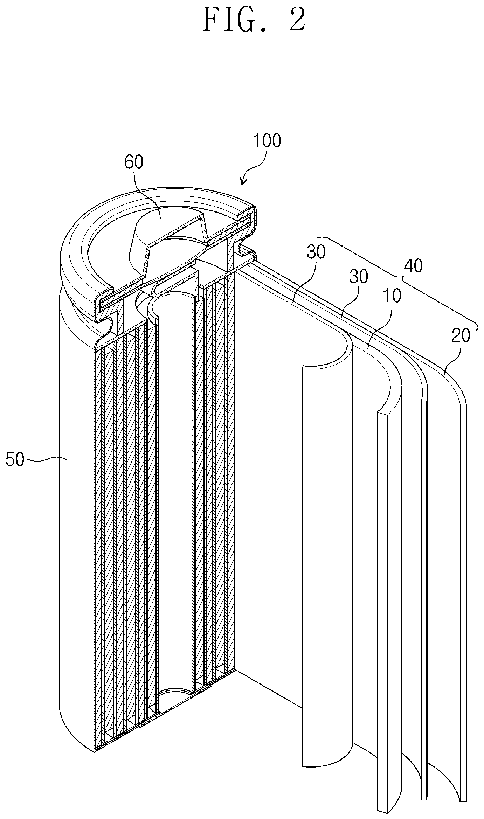

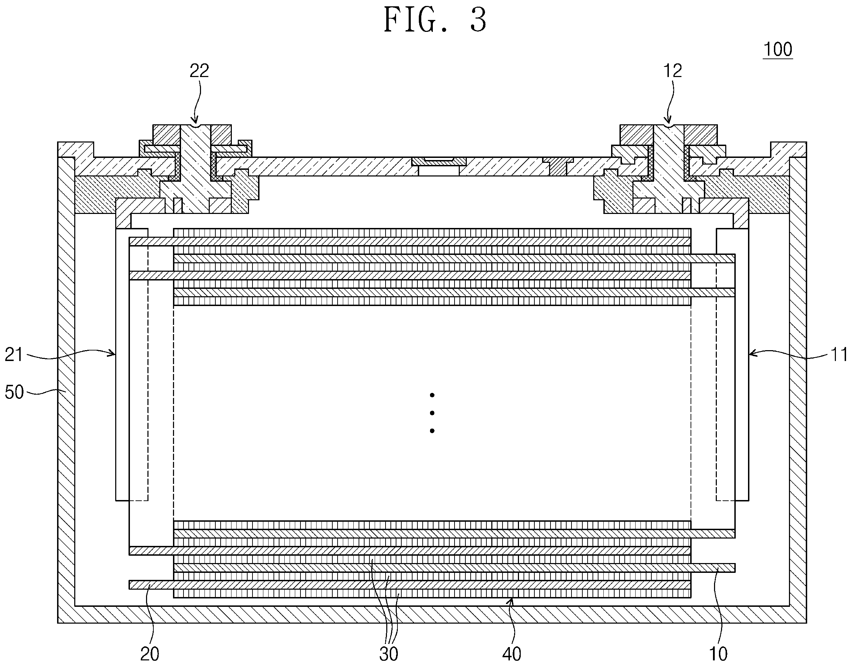

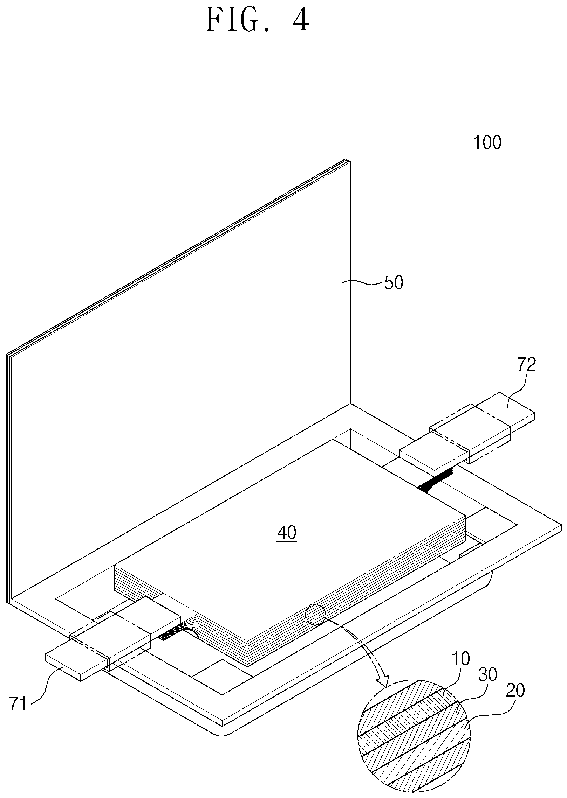

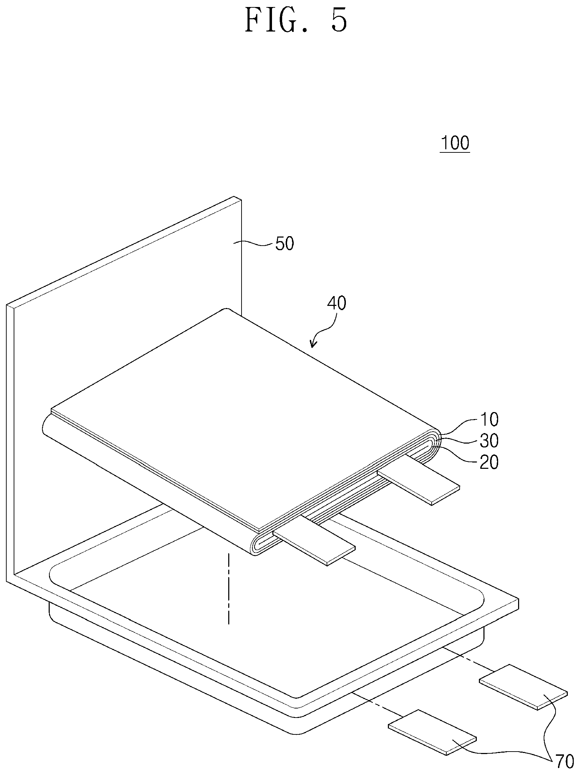

The rechargeable lithium battery may be classified into cylindrical, prismatic, pouch, or coin-type batteries, and the like depending on their shape. FIGS. 2 to 5 are schematic views illustrating a rechargeable lithium battery according to an example embodiment. FIG. 2 illustrates a cylindrical battery, FIG. 3 illustrates a prismatic battery, and FIGS. 4 and 5 illustrate pouch-type batteries. Referring to FIGS. 2 to 5, the rechargeable lithium battery 100 may include an electrode assembly 40 including a separator 30 between a positive electrode 10 and a negative electrode 20, and a case 50 in which the electrode assembly 40 is included. The positive electrode 10, the negative electrode 20, and the separator 30 may be impregnated with an electrolyte solution (not shown). The rechargeable lithium battery 100 may include a sealing member 60 sealing the case 50, as illustrated in FIG. 2. In FIG. 3, the rechargeable lithium battery 100 may include a positive lead tab 11, a positive terminal 12, a negative lead tab 21, and a negative terminal 22. As shown in FIGS. 4 and 5, the rechargeable lithium battery 100 may include an electrode tab 70 illustrated in FIG. 5, and may include, for example, a positive electrode tab 71 and a negative electrode tab 72 illustrated in FIG. 4, the electrode tabs 70/71/72 forming an electrical path for inducing the current formed in the electrode assembly 40 to the outside of the battery 100.

The rechargeable lithium battery according to an example embodiment may be applicable to, e.g., automobiles, mobile phones, and/or various types of electric devices, as non-limiting examples.

Hereinafter, the first particle PTC1, the second particle PTC2, the third particle PTC3, the first active material layer ATL1, the second active material layer ATL2, and the positive electrode having a double layer structure are described in more detail below with respect to FIGS. 6-8.

### First Particle PTC1

The first particle PTC1 includes an olivine structured lithium compound represented by Formula 1 below.

Formula 1: Liₐ₁Feₓ₁B1_{y1}PO_{4-c1}

In Formula 1 above, 0.8<a1≤1.2, 0.95≤x1≤0.999, 0.001≤y1≤0.05, x1+y1=1, and 0≤c1≤0.05 are satisfied, and B1 is or includes at least one of Ti and a transition metal having an oxidation number of 4. B1 may be or include a dopant with which the first particle PTC1 is doped.

The first particle PTC1 is provided with benefits including high economic efficiency, high structural stability, and desired or improved lifetime characteristics. The first particle PTC1 contains Fe as a component, e.g., a key component, and thus is relatively inexpensive, and has relatively small chemical changes even after repeated charging/discharging due to the structural stability thereof.

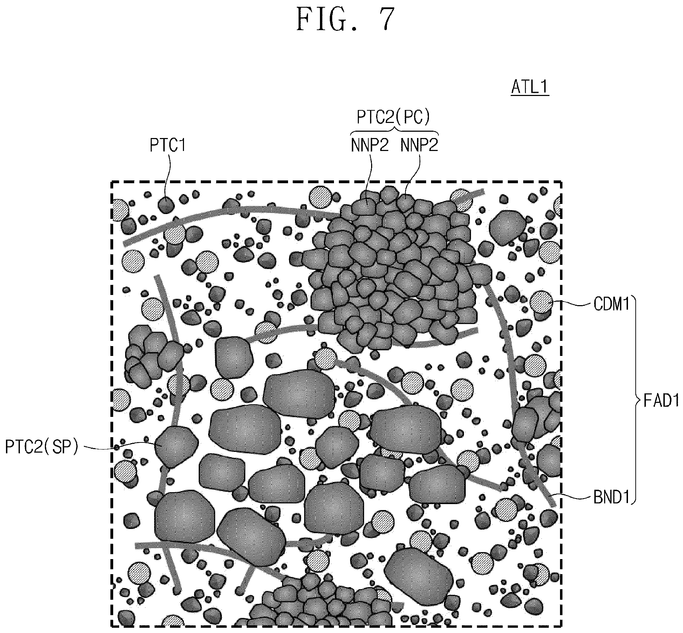

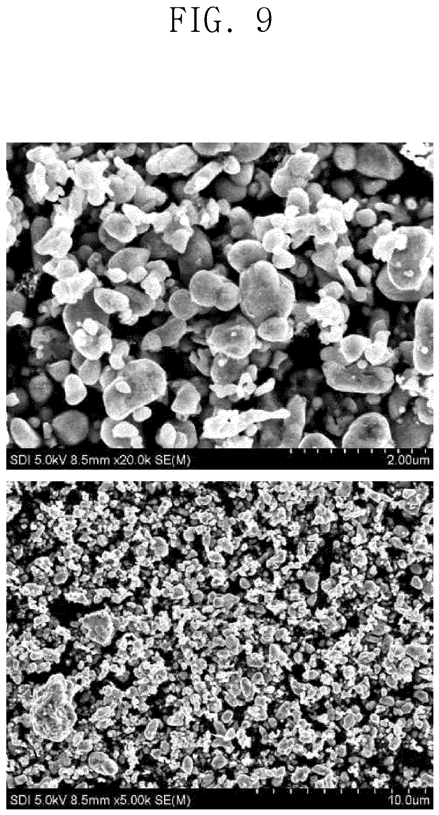

Referring to FIGS. 7 and 9, the first particle PTC1 may be in the form of a single particle. Herein, the single particle may indicate a single type of particle having no grain boundary inside thereof. The single particle may indicate one single particle morphologically present in an independent phase in which particles are not aggregated with one another, a particle having a monolith structure, a particle having a one-body structure, or a non-aggregated particle. For example, the single particle may be a single crystal. Alternatively, the single particle may be a particle containing several crystals. The single particle may be in an isolated form. Alternatively, the single particle may be in the form in which a range of about 2 to about 100 single particles are attached to one another.

The first particle PTC1 may include at least one first primary particle. In an example embodiment, the first particle PTC1 may be substantially in the shape of a sphere or an oval in which first primary particles are attached. In another example embodiment, the first particle PTC1 may not have a substantially spherical shape but may have an irregular shape even when the first primary particles are attached.

The first particle PTC1 may be provided in various sizes. For example, the first particle PTC1 may have an average particle diameter in a range of about 0.5 µm to about 2.5 µm, or about 1 µm. The minimum particle diameter of the first particles PTC1, that is, the size of the first primary particles may be about 100 nm to about 500 nm, or about 200 nm to about 300 nm.

In an example embodiment, the average particle diameter may be measured via a particle size analyzer. The average particle diameter may indicate the diameter D₅₀ of particles at an accumulated volume of about 50 vol% in particle size distribution.

In an example embodiment, the minimum particle diameter, that is, the size of the first primary particles may indicate the diameter measured by randomly selecting about 30 primary particles on an electron microscope image of the first particles PTC1.

The dopant may have the effect of controlling the uniform growth of the first primary particles of the first particle PTC1, and may thus allow rechargeable lithium batteries to have improved charging/discharging efficiency, low-temperature characteristics, and lifetime characteristics.

In an example embodiment, the first particle PTC1 may include a coating layer on a surface thereof. The coating layer may entirely cover the surface of the first particle PTC1, or may partially cover the surface of the first particle PTC1. For example, the coating layer may include carbon and/or a carbon-containing compound. The first particle PTC1 may have an improved structural stability and electrical conductivity through the coating layer.

The coating layer may further include at least one of titanium and a transition metal having an oxidation number of 4. Metal-containing compounds, such as titanium-containing compounds and transition metal-containing compounds having an oxidation number of 4, may be or include, for example, at least one of metal oxides, metal hydroxides, metal carbonates, composites thereof, or mixtures thereof. The metal-containing compounds may further include other metals or non-metallic elements. For example, the metal-containing compounds may further include lithium.

The first particle PTC1 further includes a coating portion, and may thus have greater structural stability and may have a uniform coating layer formed on the surface thereof. In addition, the first particle PTC1 further includes a coating portion, and may thus have further improved electrical conductivity.

The first particle PTC1 may further include carbon derived from the coating layer described above. The first particle PTC1 may have a carbon element content in a range of about 0.5 wt% to about 5 wt%, about 0.5 wt% to about 3 wt%, or about 1.0 wt% to about 2.0 wt%. The first particle PTC1 may have a lower carbon element content than the third particle PTC3. The amount of carbon may be measured using Thermogravimetric Analysis (TGA), CHNS Elemental Analysis, or X-ray Photoelectron Spectroscopy (XPS).

### Second Particle PTC2

The second particle PTC2 includes a layered lithium compound represented by Formula 2 below.

Formula 2: Liₐ₂Niₓ₂Co_{y2}B2_{z2}O_{2-c2}

In Formula 2 above, 0.8<a2≤1.2, 0.9≤x2≤1.05, 0.03≤y2≤0.10, 0.01≤z2≤0.05, and 0≤c2≤0.05 are satisfied, and B2 is or includes at least one of Al and Mn.

B2 may be or include Al.

In one or more embodiments, in Chemical Formula 2, 0.9≤x2≤0.94, 0.05≤y2≤0.09, 0.01≤z2≤0.05, x2+y2+z2=1, and 0≤c2≤0.05 may be satisfied.

The second particle PTC2 provides benefits such as, e.g., high capacity and high energy density.

The second particle PTC2 is or includes a nickel-based active material, and includes lithium nickel-based composite oxide. For example, the second particle PTC2 includes a high nickel-based positive electrode active material containing a high content of nickel. The high nickel-based positive electrode active material may achieve high capacity and high performance.

In an example embodiment, the second particle PTC2 may include a second coating layer on a surface thereof. The second particle PTC2 includes the second coating layer, and may thus effectively reduce or prevent structural collapse caused by repeated charging/discharging. Accordingly, rechargeable batteries may have improved lifetime characteristics.

The second coating layer may include at least one of an aluminium-containing compound, a titanium-containing compound, a magnesium-containing compound, a zirconium-containing compound, a molybdenum-containing compound, a niobium-containing compound, or a combination thereof. Metal-containing compounds in the second coating layer may be or include, for example, at least one of metal oxides, metal hydroxides, metal carbonates, composites thereof, or mixtures thereof. The metal-containing compounds may further include other metals or non-metallic elements. For example, the second coating layer may further include at least one of lithium, manganese, and/or nickel.

A method of measuring the metal content in the second coating layer of the second particle PTC2 may include performing scanning electron microscopy and energy dispersive X-ray spectroscopy (SEM-EDS) on the second particle PTC2. Through the analysis described above, the content of aluminium, titanium, magnesium, zirconium, molybdenum, and/or niobium in the second coating layer may be determined. In addition to SEM-EDS, methods of measuring the metal content in the second coating layer may include inductively coupled plasma-mass spectrometry (ICP-MS), inductively coupled plasma optical emission spectroscopy (ICP-OES), and the like.

The second particle PTC2 may have a smaller Brunauer-Emmett-Teller (BET) specific surface area than the first particle PTC1. The second particle PTC2 may have a BET specific surface area in a range of about 0.3 m²/g to about 0.6 m²/g. The BET specific surface area may indicate a surface area per unit mass. The BET specific area can be measured by various methods. For example, the BET specific area can be measured using a BET analyzer (e.g., Micromeritics TriStar, Quantachrome NOVA, Autosorb IQ, etc.) As the BET is smaller, a contact surface between a positive electrode active material and a current collector decreases, resulting in reduced resistance and greater bindability with respect to an electrode plate. That is, the positive electrode active material containing the second particles PTC2 having a small BET specific surface area may facilitate preparation of an electrode plate even with a small amount of binder.

The second particle PTC2 may be in the form of a single particle and/or a secondary particle. For example, the second particle PTC2 may be present only in the form of a single particle, only in the form of a secondary particle, or in a mixed form of a single particle and a secondary particle. In an example embodiment, the second particle PTC2 may have further improved density when having a bimodal form in which single particles and secondary particles are mixed. Hereinafter, the second particle PTC2 in the form of a single particle and/or in the form of a secondary particle is described with reference to FIGS. 7, 10, and 11.

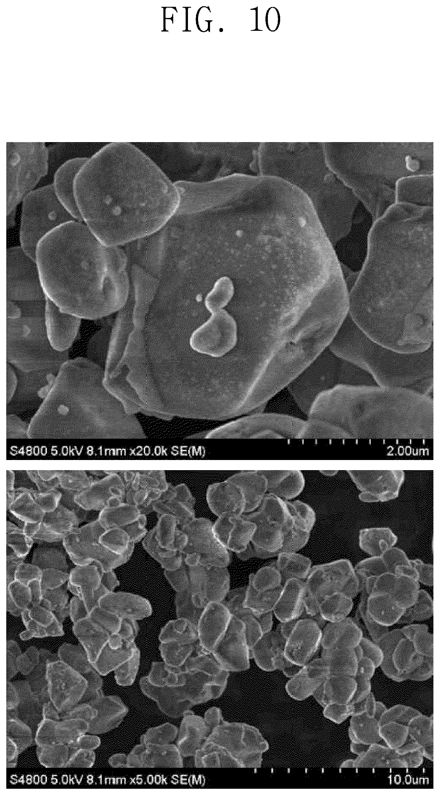

In an example embodiment, referring to FIG. 10, the second particle PTC2 may be in the form of a single particle. Herein, the single particle may indicate a single type of particle having no grain boundary inside thereof. The single particle may indicate one single particle morphologically present in an independent phase in which particles are not aggregated with one another, a particle having a monolith structure, a particle having a one-body structure, or a non-aggregated particle. For example, the single particle may be a single crystal. Alternatively, the single particle may be a particle containing several crystals. The single particle may be in an isolated form. Alternatively, the single particle may be in the form in which a range of about 2 to about 100 single particles are attached to one another.

When the second particle PTC2 is a single particle, the second particle PTC2 may include at least one second primary particle. In an example embodiment, the second particle PTC2 may be substantially in the shape of sphere or oval in which second primary particles are attached. In another example embodiment, the second particle PTC2 may not have a substantially spherical shape but may have an irregular shape even when the second primary particles are attached. The second particle PTC2, in the form of a single particle in which second primary particles are attached, may be less structured than when it is in the form of a secondary particle. This means the second particle PTC2 may be in a more irregular form.

When the second particle is a single particle, the second particle PTC2 may have an average particle diameter in a range of about 3 µm to about 10 µm. The average particle diameter of the second particles PTC2 may be greater than the above-described average particle diameter of the first particles PTC1. In an example embodiment, the average particle diameter may be measured through a particle size analyzer. The particle diameter may indicate a diameter (D₅₀) of the particles at an accumulated volume of about 50 vol% in particle size distribution. The average particle diameter (D₅₀) of the second particle may be greater than the average particle diameter (D₅₀) of each, or at least one, of the first particle described above and the third particle which is described below.

Referring to FIGS. 9 and 10, when the second particle PTC2 is a single particle, the average size of the second primary particles of the second particle PTC2 is greater than the average size of the first primary particles of the first particle PTC1.

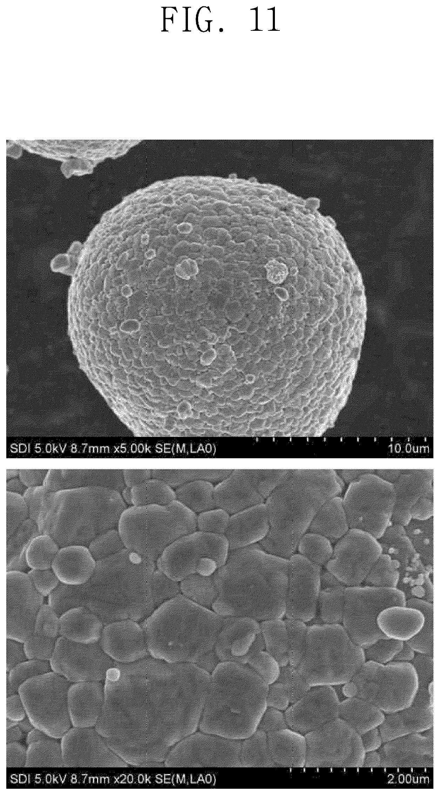

In another example embodiment, referring to FIG. 11, the second particle PTC2 may be in the form of a secondary particle. The secondary particle may be in the form of a polycrystal, indicating the form in which at least two second primary particles are aggregated. That is, one second particle PTC2 may include a plurality of second primary particles NNP2 (FIG. 7) aggregated together. The second particle PTC2 may be substantially in the shape of sphere or oval.

When the second particle is a secondary particle, the second particle PTC2 may have an average particle diameter in a range of about 10 µm to about 14 µm. Referring to FIGS. 9 and 11, the average particle diameter of the second particle PTC2 may be greater than the above-described average particle diameter of the first particle PTC1. In an example embodiment, the average particle diameter may be measured through a particle size analyzer. The particle diameter may indicate a diameter (D₅₀) of the particles at an accumulated volume of about 50 vol% in particle size distribution.

In another example embodiment, referring to FIG. 7, the second particle may be present in a bimodal form in which single particles PTC2(SP) and secondary particles PTC2(PC) are mixed. The second particle may have further improved density when having a bimodal form. To describe FIG. 7 in more detail, the second particle PTC2(PC), which is a secondary particle, indicate the form in which at least two second primary particles NNP2 are aggregated. The second particle PTC2(SP), which is a single particle, may indicate the form including at least one second primary particle. The second particle PTC2(SP), which is a single particle has a greater size of second primary particles than the second particle PTC2(PC), which is a secondary particle, and may not have a substantially spherical shape, but may have an irregular shape even when the second primary particles agglomerate.

### Third Particle PTC3

The third particle PTC3 may include an olivine structured lithium compound represented by Formula 3 restated below.

Formula 3: Liₐ₃Feₓ₃B3_{y3}PO_{4-c3}

In Formula 3 above, 0.8<a3≤1.2, 0.95≤x3≤0.999, 0.001≤y3≤0.05, x3+y3=1, and 0≤c3≤0.05 are satisfied, and B3 is or includes at least one of Ti and a transition metal having an oxidation number of 4. B3 may be or include a dopant with which the third particle PTC3 is doped.

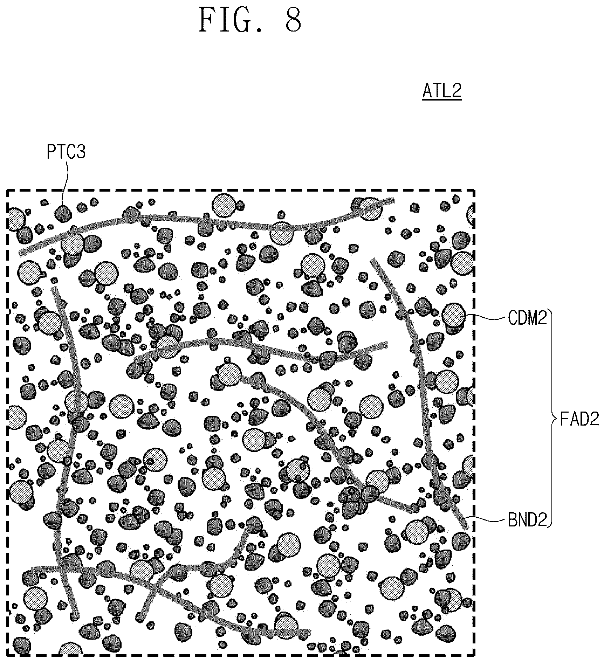

The third particle PTC3 illustrated in FIG. 8 is provided with benefits including high economic efficiency, high structural stability, and desired or improved lifetime characteristics. The third particle PTC3 contains Fe as a key component, and thus is relatively inexpensive, and has relatively small chemical changes even after repeated charging/discharging due to the structural stability thereof.

The dopant may have the effect of controlling the uniform growth of the third primary particles of the third particle PTC3, and may thus allow rechargeable lithium batteries to have improved charging/discharging efficiency, low-temperature characteristics, and lifetime characteristics.

In an example embodiment, the third particle PTC3 may include a coating layer on a surface thereof. The coating layer may entirely cover the surface of the third particle PTC3, or may partially cover the surface of the third particle PTC3. For example, the coating layer may include carbon and/or a carbon-containing compound. The third particle PTC3 may have improved structural stability and electrical conductivity through the coating layer.

The coating layer may further include at least one of titanium and a transition metal having an oxidation number of 4. Metal-containing compounds, such as titanium-containing compounds and transition metal-containing compounds having an oxidation number of 4, may be or include, for example, at least one of metal oxides, metal hydroxides, metal carbonates, composites thereof, or mixtures thereof. The metal-containing compounds may further include other metals or non-metallic elements. For example, the metal-containing compounds may further include lithium.

The third particle PTC3 may further include a coating portion, and may thus have a greater structural stability and may have a uniform coating layer formed on the surface thereof. In addition, the third particle PTC3 may further include a coating portion, and may thus have further improved electrical conductivity.

The third particle PTC3 may further include carbon derived from the coating layer described above. The third particle PTC3 may have a carbon element content in a range of about 0.5 wt% to about 5 wt%, about 0.5 wt% to about 3 wt%, or about 1.0 wt% to about 2 wt%.

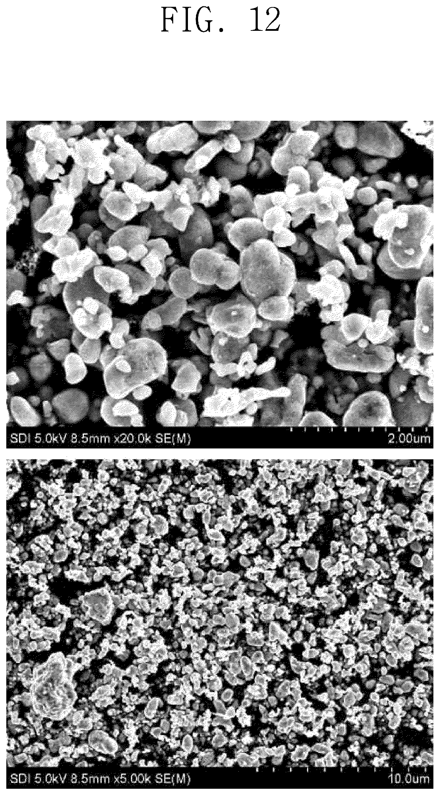

Referring to FIG. 12, the third particle PTC3 is in the form of a single particle. Herein, the single particle may indicate a single type of particle having no grain boundary inside thereof. The single particle may indicate one single particle morphologically present in an independent phase in which particles are not aggregated with one another, a particle having a monolith structure, a particle having a one-body structure, or a non-aggregated particle. For example, the single particle may be a single crystal. Alternatively, the single particle may be a particle containing several crystals. The single particle may be in an isolated form. Alternatively, the single particle may be in the form in which a range of about 2 to about 100 single particles are attached to one another.

The third particle PTC3 may include at least one third primary particle. In an example embodiment, the third particle PTC3 may be substantially in the shape of sphere or oval in which third primary particles are attached. In another example embodiment, the third particle PTC3 may not have a substantially spherical shape but may have an irregular shape even when the third primary particles are attached.

The third particle PTC3 may have various sizes. For example, the third particle PTC3 may have an average particle diameter in a range of about 0.5 µm to about 2.5 µm, or about 1 µm. The minimum particle diameter of the third particle PTC3, that is, the size of the third primary particles may be about 100 nm to about 500 nm, or about 200 nm to about 300 nm.

In an example embodiment, the average particle diameter may be measured through a particle size analyzer. The average particle diameter may indicate the diameter D₅₀ of particles at an accumulated volume of about 50 vol% in particle size distribution.

In an example embodiment, the minimum particle diameter, that is, the size of the third primary particles, may indicate the diameter measured by randomly selecting about 30 primary particles on an electron microscope image of the third particle PTC3.

### First Active Material Layer ATL1

FIG. 7 is an enlarged view illustrating a first active material layer ATL1 of a positive electrode for a rechargeable lithium battery, according to example embodiments of the present disclosure.

Referring to FIG. 7, the first active material layer ATL1 includes a first particle PTC1, a second particle PTC2, and a first functional additive FAD1. The first functional additive FAD1 includes a first binder BND1 and a first conductive material CDM1. Although not shown in the drawing, the second particle PTC2 may be in the form of a secondary particle, or may be in a bimodal form which is a mixed form of single particles and secondary particles.

The first active material layer ATL1 includes a mixture of the first particle PTC1 and the second particle PTC2, thereby making up for low capacity and low energy density, which are limitations of lithium iron phosphate-based positive electrode active materials. That is, benefits such as economic efficiency of the first particle PTC1 and high capacity and high energy density of the second particle PTC2 may be achieved together.

The first active material layer ATL1 has a mixture of the first particle PTC1 and the second particle PTC2 having a small BET, and accordingly, a weight ratio of the first functional additive FAD1 in the first active material layer ATL1 may be reduced. The weight ratio of the first functional additive FAD1 in the first active material layer ATL1 may be defined as a weight of the first functional additive FAD1 with respect to a total weight of the first active material layer. When the particle size is too small, the bondability between the current collector and the positive electrode active material can be reduced, which can increase resistance. As a result, the electrode plate may become challenging to process, and a larger quantity of binder may be required. The first active material layer ATL1 according to an example embodiment of the present disclosure includes the second particle PTC2, which has a smaller BET than lithium iron phosphate-based positive electrode active materials. This allows the first active material layer (ATL1) to facilitate the preparation of an electrode plate.

For example, the weight ratio of the first functional additive FAD1 in the first active material layer ATL1 may be in a range of about 2.4 to about 4.0 (e.g. about 2.4 parts by weight to about 4.0 parts by weight with respect to 100 parts by weight of the first active material layer ATL1).

The weight ratio of the first functional additive FAD1 in the first active material layer ATL1 may be lower than or the same as the weight ratio of the second functional additive FAD2 in the second active material layer ATL2, which is described below. A ratio of the weight ratio of the second functional additive FAD2 to the weight ratio of the first functional additive FAD1 is in a range of about 1.0 to about 2.6, for example, about 1.0 to about 2.44.

The content of the first binder BND1 may be in a range of about 1.2 parts by weight to about 2.0 parts by weight with respect to 100 parts by weight of the first active material layer ATL1. The content of the first conductive material CDM1 may be in a range of about 1.2 parts by weight to about 2.0 parts by weight with respect to 100 parts by weight of the first active material layer ATL1. The content of the first binder BNDI in the first active material layer ATL1 may be lower than the content of the second binder BND2 in the second active material layer ATL2, which is described below. When the first active material layer ATL1 satisfies the ranges in the content of the first binder and the first conductive material, the capacity and energy density of batteries may be maximized and an electrode plate may be readily processed.

The first binder BND1 is configured to attach the positive electrode active material particles PTC1 and PTC2, and also to attach the positive electrode active materials PTC1 and PTC2 to the current collector COL1. Typical examples of the first binder BND1 may be or include at least one of polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinyl pyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but the example embodiment of the present disclosure is not limited thereto.

The first conductive material CDM1 may be configured to impart conductivity to an electrode. Any material that does not cause chemical changes to the battery, and that is an electron conductive material, may be included in the battery. Examples of the first conductive material CDM1 may include a carbon-based material such as at least one of natural graphite, artificial graphite, carbon black, acetylene black, ketjen black, a carbon fiber, a carbon nanofiber, and a carbon nanotube; a metal-based material including at least one of copper, nickel, aluminium, silver, etc. in a form of a metal powder or a metal fiber; a conductive polymer such as a polyphenylene derivative; or a mixture thereof.

The first active material layer ATL1 may be in contact with one surface of the current collector COL1 (FIG. 6).

The first active material layer ATL1 may have a thickness T1. In an example embodiment, T1 may increase with a rise in weight of the first particle PTC1 and/or the second particle PTC2 included in the first active material layer ATL1.

The first active material layer ATL1 may contain less carbon than the second active material layer ATL2 further discussed below. The content of carbon included in the first active material layer may be defined as the content of carbon element included in the first active material layer with respect to the weight of the first active material layer. That is, the content of carbon included in the first active material layer may be defined as weight of carbon element included in the first active material layer/weight of the first active material layer. The content of carbon element may be measured, for example, via carbon-sulfur analysis. However, methods of measuring are not limited to thereto.

### Second Active Material Layer ATL2

FIG. 8 is an enlarged view showing a second active material layer ATL2 of a positive electrode for a rechargeable lithium battery according to example embodiments of the present disclosure.

Referring to FIG. 8, the second active material layer ATL2 includes a third particle PTC3 and a second functional additive FAD2. The second functional additive FAD2 includes a second binder BND2 and a second conductive material CDM2.

The second binder BND2 is configured to attach the positive electrode active material particles PTC3 well. Typical examples of the second binder BND2 may be or include at least one of polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinyl pyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but the example embodiment of the present disclosure is not limited thereto. The second binder BND2 may or may not be the same as the first binder BND1 described above.

The second conductive material CDM2 may be configured to impart conductivity to an electrode. Any material that does not cause chemical changes and that is an electron conductive material may be included in the battery. Examples of the second conductive material CDM2 may include a carbon-based material such as at least one of natural graphite, artificial graphite, carbon black, acetylene black, ketjen black, a carbon fiber, a carbon nanofiber, and a carbon nanotube; a metal-based material including at least one of copper, nickel, aluminium, silver, etc. in a form of a metal powder or a metal fiber; a conductive polymer such as a polyphenylene derivative; or a mixture thereof. The second conductive material CDM2 may or may not be the same as the first conductive material CDM1 described above.

The content of the second binder BND2 may be in a range of about 2.0 parts by weight to about 3.0 parts by weight with respect to 100 parts by weight of the second active material layer ATL2. The content of the second conductive material CDM2 may be in a range of about 2.0 parts by weight to about 3.0 parts by weight with respect to 100 parts by weight of the second active material layer ATL2. The content of the second binder BND2 in the second active material layer ATL2 may be greater than the content of the first binder BND1 in the first active material layer ATL1 described above. Alternatively, the content of the second binder BND2 in the second active material layer ATL2 with respect to the content of the first binder BND1 in the first active material layer ATL1 described above may be in a range of about 1.0 to about 2.5 (e.g. a ratio of about 1.0 to about 2.5), about 1.0 to about 2.44 (e.g. a ratio of about 1.0 to about 2.44), or about 1.3 to about 1.8 (e.g. a ratio of about 1.3 to about 1.8).

When the second active material layer ATL2 satisfies the above ranges in the content of the second conductive material and the second binder, the capacity of batteries may be maximized and an electrode plate may be readily processed.

The weight ratio of the second functional additive FAD2 in the second active material layer ATL2 may be greater than the weight ratio of the first functional additive FAD1 in the first active material layer ATL1. The weight ratio of the second functional additive FAD2 in the second active material layer ATL2 may be in a range of about 4.0 to about 6.0 (e.g. about 4.0 parts by weight to about 6.0 parts by weight with respect to 100 parts by weight of the second active material layer ATL2).

A ratio of the weight ratio of the second functional additive FAD2 to the weight ratio of the first functional additive FAD1 (weight ratio of the second functional additive/weight ratio of the first functional additive) is in a range of about 1.0 to about 2.6, for example, about 1.0 to about 2.44. When the ratio of the weight ratio of the second functional additive FAD2 to the weight ratio of the first functional additive FAD1 satisfies any of the numerical ranges described above, the positive electrode active material layer AML1 has improved bindability with respect to the current collector COL1, and accordingly, the capacity and energy density of batteries may be improved or maximized and an electrode plate may be readily processed.

The second active material layer ATL2 may be applied to be in contact with one surface of the first active material layer ATL1. One surface of the first active material layer ATL1 may be a surface that is not in contact with the current collector COL1 (FIG. 6). For example, the current collector COL1 (FIG. 6), the first active material layer ATL1, and the second active material layer ATL2 may be sequentially disposed.

The second active material layer ATL2 may have a thickness T2. In an example embodiment, T2 may increase with a rise in weight of the third particle PTC3 included in the second active material layer ATL2.

### Positive Electrode including First Active Material Layer and Second Active Material Layer

FIG. 6 is a cross-sectional view showing a positive electrode for a rechargeable lithium battery according to example embodiments of the present disclosure. Referring to FIG. 6, as described above, the positive electrode 10 includes a current collector COL1 and a positive electrode active material layer AML1. The positive electrode active material layer AML1 is located on the current collector COL1.

The positive electrode active material layer AML1 includes positive electrode active materials PTC1, PTC2, and PTC3. The positive electrode active material layer AML1 may contain a range of about 90 wt% to about 99 wt% of the positive electrode active materials PTC1, PTC2, and PTC3 with respect to 100 wt% of the positive electrode active material layer AML1.

The positive electrode active material layer AML1 includes binders BND1 and BND2 and conductive materials CDM1 and CDM2. The positive electrode active material layer AML1 may contain a range of about 0.5 wt% to about 5 wt% of each, or at least one, of the binders BND1 and BND2 and the conductive materials CDM1 and CDM2 with respect to 100 wt% of the positive electrode active material layer AML1.

The positive electrode active material layer AML1 includes a first active material layer ATL1 and a second active material layer ATL2. Since the first active material layer ATL1 is placed underneath the second active material layer ATL2, the positive electrode active material layer AML1 can contain a large amount of nano-sized olivine-based compound while increasing the bindability to the current collector. As a result, the electrode plate can be readily manufactured, and the resistance of the electrode plate can be reduced. For example, this configuration leads to a lithium secondary battery with desired or improved performance.

The first active material layer ATL1 may have a thickness T1. In an example embodiment, T1 may increase with a rise in weight of the first particle PTC1 and/or the second particle PTC2 included in the first active material layer ATL1. The second active material layer ATL2 may have a thickness T2. In an example embodiment, T2 may increase with a rise in weight of the third particle PTC3 included in the second active material layer ATL2.

A thickness ratio T1:T2 of the first active material layer ATL1 and the second active material layer ATL2 may be a range of about 3:7 to about 7:3. For example, the thickness ratio T1:T2 of the first active material layer ATL1 and the second active material layer ATL2 may be about 5:5. When the thickness ratio T1:T2 of the first active material layer ATL1 and the second active material layer ATL2 satisfies any of the numerical ranges described above, the positive electrode active material layer AML1 has improved bindability with respect to the current collector COL1, and accordingly, the capacity and energy density of batteries may be improved or maximized, and an electrode plate may be readily processed.

In an example embodiment of the present disclosure, as shown in FIGS. 6 and 7, the first active material layer ATL1 is introduced between the current collector COL1 and the second active material layer ATL2. The first active material layer ATL1 contains the second particle PTC2 and the first particle PTC1 in an appropriate ratio. The configuration may improve the bindability of the electrode plate and may reduce the requirement for the binder BND. Furthermore, it may lead to improvements in capacity, density characteristics, high temperature stability, and lifetime characteristics. Moreover, the inclusion of the second particle PTC2 in a bimodal form, comprising a mixture of single particles and secondary particles, further enhances density.

The first particle PTC1 may amount to a range of about 30 wt% to about 40 wt%, with respect to a total content of the first particle PTC1, the second particle PTC2, and the third particle PTC3 included in the first active material layer ATL1 and the second active material layer ATL2. For example, with respect to a total content of the first particle PTC1, the second particle PTC2, and the third particle PTC3 included in the first active material layer ATL1 and the second active material layer ATL2, the first particle PTC1 may amount to about 35 wt%.

The second particle PTC2 may amount to a range of about 10 wt% to about 30 wt%, with respect to a total content of the first particle PTC1, the second particle PTC2, and the third particle PTC3 included in the first active material layer ATL1 and the second active material layer ATL2. For example, with respect to a total content of the first particle PTC1, the second particle PTC2, and the third particle PTC3 included in the first active material layer ATL1 and the second active material layer ATL2, the second particle PTC2 may amount to a range of about 20 wt% to about 30 wt%.

The third particle PTC3 may amount to a range of about 30 wt% to about 40 wt%, with respect to a total content of the first particle PTC1, the second particle PTC2, and the third particle PTC3 included in the first active material layer ATL1 and the second active material layer ATL2. For example, with respect to a total content of the first particle PTC1, the second particle PTC2, and the third particle PTC3 included in the first active material layer ATL1 and the second active material layer ATL2, the third particle PTC3 may amount to about 35 wt%.

The second particle PTC2 may amount to a range of about 30 wt% to about 60 wt%, with respect to a total content of the first particle PTC1 and the second particle PTC2 included in the first active material layer ATL1. For example, with respect to a total content of the first particle PTC1 and the second particle PTC2 included in the first active material layer ATL1, the second particle PTC2 may amount to a range of about 45 wt% to about 50 wt%.

When the content of the first particle PTC1, the second particle PTC2, and the third particle PTC3 satisfies any of the ranges described above, the positive electrode active material layer AML1 may have improved bindability with respect to the current collector COL1. Accordingly, a rechargeable lithium battery having reduced resistance may be provided. In addition, when the content of the first particle PTC1, the second particle PTC2, and the third particle PTC3 satisfies any of the ranges described above, a rechargeable lithium battery having desired or improved performance may be provided.

Hereinafter, Preparation Examples, Examples, and Comparative Examples of the present disclosure is described. However, the following Examples are presented only as an example embodiment of the present disclosure, and the present disclosure is not limited by the following Examples.

### Preparation Example 1: Preparation of First Particle

An iron phosphate precursor (Fe₁PO₄), lithium carbonate, and titanium dioxide were mixed at a molar ratio of Fe:Li:Ti=1:1.03:0.004. 10 wt% of glucose was further added to the mixture. The mixture was subjected to a wet grinding process through ball milling. The mixture was evaporated to dryness on a heating tray and subsequently placed and dried in a vacuum oven at 85 °C for 4 hours. The dried mixture was fired at 750 °C for 10 hours in a nitrogen atmosphere. The fired product was ground at a rotation speed of 8000 rpm to obtain a first particle in the form of a single particle. The first particle had an average particle diameter of 0.5 µm to 2.5 µm. First primary particles of the first particle had a size of 200 nm to 300 nm.

### Preparation Example 2: Preparation of Second Particle (Single Particle Form)

Ni_{0.92}Co_{0.07}Al_{0.01}(OH)₂ and LiOH were mixed at a molar ratio of (Ni+Co+Al):Li=1:1.05 and the mixture was subjected to a first heat treatment at 810 °C for 8 hours in an oxygen atmosphere to obtain an oxide having a composition of Li_{1.05}Ni_{0.92}Co_{0.07}Al_{0.01}O₂ and an average particle diameter (D₅₀) of about 4 µm. Aluminium oxide was added to the oxide, and the mixture was subsequently subjected to a second heat treatment at 740 °C for 8 hours in an oxygen atmosphere to prepare a positive electrode active material. The second particle was represented by Formula of LiNi_{0.92}Co_{0.07}Al_{0.01}O₂.

### Preparation Example 3: Preparation of Third Particle

An iron phosphate precursor (Fe₁PO₄), lithium carbonate, and titanium dioxide were mixed at a molar ratio of Fe:Li:Ti= 1:1.03:0.004. 10 wt% of glucose was further added to the mixture. The mixture was subjected to a wet grinding process through ball milling. The mixture was evaporated to dryness on a heating tray and subsequently placed and dried in a vacuum oven at 85 °C for 4 hours. The dried mixture was fired at 750 °C for 10 hours in a nitrogen atmosphere. The fired product was ground at a rotation speed of 8000 rpm to obtain a third particle in the form of a single particle. The third particle had an average particle diameter of 0.5 µm to 2.5 µm. Third primary particles of the third particle had a size of 200 nm to 300 nm.

### Example 1: Preparation of Positive Electrode including First Active Material Layer and Second Active Material Layer

The first particle of Preparation Example 1 and the second particle of Preparation Example 2 were dispersed in N-methylpyrrolidone along with a conductive material (carbon black) and a binder (polyvinylidene fluoride) to prepare a first positive electrode active material slurry. The third particle of Preparation Example 3 was dispersed in N-methylpyrrolidone along with a conductive material (carbon black) and a binder (polyvinylidene fluoride) to prepare a second positive electrode active material slurry.

The first positive electrode active material slurry was applied onto a positive electrode current collector and dried to form a first active material layer. The second positive electrode active material slurry was applied onto the first active material layer and dried to form a second active material layer.

In this case, an active material layer was formed such that the first particle, the second particle, and the third particle in the double layer positive electrode were present at a weight ratio of 35:30:35. Through a roll press, a positive electrode in which the current collector, the first active material layer, and the second active material layer were stacked in this order was prepared.

### Example 2

A positive electrode was prepared in the same manner as in Example 1, with a difference that the second particle in a bimodal form was used instead of the second particle (single particle form) from Preparation Example 2. The method for preparing second particles in a bimodal form is as follows. Ni_{0.92}Co_{0.07}Al_{0.01}(OH)₂ and LiOH were mixed at a molar ratio of (Ni+Co+Al):Li=1:1.05, and a flux was added to the mixture. The mixture was then subjected to a first heat treatment at 750 °C for 15 hours in an oxygen atmosphere to obtain first heat-treated particles. The first heat-treated particles were milled using a jet mill at a pressure of 3 bar and subsequently washed with distilled water. After washing, aluminum oxide was added to the particles, and the mixture was dried at 150°C for 12 hours. The dried mixture was then subjected to a second heat treatment at 700°C for 15 hours in an oxygen atmosphere to prepare the second particle in the form of a secondary particle. The second particle in the form of secondary particle and the second particle in the form of primary particle from Preparation Example 2 were mixed at a weight ratio of 2:8 to prepare a bi-modal second particle.

### Comparative Example 1: Preparation of Positive Electrode including One Active Material Layer

The first particle of Preparation Example 1 and the second particle of Preparation Example 2 were mixed at a weight ratio of 30:70 and dispersed in N-methylpyrrolidone along with a conductive material (carbon black) and a binder (polyvinylidene fluoride) to prepare a positive electrode active material slurry. The positive electrode active material slurry was applied onto a positive electrode current collector and dried to prepare a single layer positive electrode.

### Comparative Example 2

A positive electrode was prepared in the same manner as in Comparative Example 1, with a difference that the first particle of Preparation Example 1 and the second particle of Preparation Example 2 were mixed at a weight ratio of 40:60.

### Comparative Example 3

A positive electrode was prepared in the same manner as in Comparative Example 1, with a difference that the first particle of Preparation Example 1 and the second particle of Preparation Example 2 were mixed at a weight ratio of 50:50.

### Comparative Example 4

A positive electrode was prepared in the same manner as in Comparative Example 1, with a difference that the first particle of Preparation Example 1 and the second particle of Preparation Example 2 were mixed at a weight ratio of 60:40.

### Comparative Example 5

A positive electrode was prepared in the same manner as in Comparative Example 1, with a difference that the first particle of Preparation Example 1 and the second particle of Preparation Example 2 were mixed at a weight ratio of 70:30.

### Comparative Example 6

A positive electrode was prepared in the same manner as in Comparative Example 1, with a difference that the first particle of Preparation Example 1 and the second particle of Preparation Example 2 were mixed at a weight ratio of 80:20.

### Comparative Example 7

A positive electrode was prepared in the same manner as in Comparative Example 1, with a difference that the first particle of Preparation Example 1 and the second particle of Preparation Example 2 were mixed at a weight ratio of 90:10.

### Comparative Example 8

The first particle of Preparation Example 1, the second particle of Preparation Example 2, and the third particle of Preparation Example 3 were mixed at a weight ratio of 35:30:35 and dispersed in N-methylpyrrolidone along with a conductive material (carbon black) and a binder (polyvinylidene fluoride) to prepare a positive electrode active material slurry. The positive electrode active material slurry was applied onto a positive electrode current collector and dried to prepare a single layer positive electrode.

### Comparative Example 9

A positive electrode was prepared in the same manner as in Example 1, with a difference that the weights of the first binder, the first conductive material, the second binder, and the second conductive material were changed. The weight change was regulated such that a ratio of the weight ratio of the second functional additive to the weight ratio of the first functional additive was 0.75.

### Comparative Example 10

A positive electrode was prepared in the same manner as in Example 1, with a difference that the weights of the first binder, the first conductive material, the second binder, and the second conductive material were changed. The weight change was regulated such that a ratio of the weight ratio of the second functional additive to the weight ratio of the first functional additive was 3.25.

### Preparation of Rechargeable Lithium Battery

A 2032 type coin half-cell was prepared using the prepared positive electrode and a lithium metal counter electrode as a counter electrode. A separator (thickness: about 16 µm) formed a porous polyethylene (PE) film was placed between the positive electrode and the lithium metal counter electrode, and an electrolyte solution was injected to prepare a rechargeable lithium battery. As an electrolyte, an electrolyte solution obtained by mixing 1.3 M LiPF₆ with a mixed solvent containing ethylene carbonate (EC), ethylmethyl carbonate (EMC), and dimethyl carbonate (DMC) in a volume ratio of 3:4:3 was used.

### Evaluation Example 1: Analysis of Positive Electrode Active Material Surface

SEM images for each of the first, second, and third particles prepared in Preparation Examples 1 to 3 are shown in FIGS. 9, 10, and 12.

Referring to FIG. 9, the first particle according to Preparation Example (Preparation Example 1) of the present disclosure is in the form of a single particle.

Referring to FIG. 10, the second particle according to Preparation Example (Preparation Example 2) of the present disclosure is in the form of a micro-sized single particle. Referring to FIGS. 9 and 10, when the second particle is in the form of a single particle, the average particle diameter (D₅₀) of the second particle is greater than the average particle diameter (D₅₀) of the first particle.

Referring to FIG. 11, the second particle according to an example embodiment of the present disclosure is in the form of a substantially spherical secondary particle in which nano-sized fine primary particles are aggregated.

Referring to FIG. 12, the third particle according to Preparation Example (Preparation Example 3) of the present disclosure is in the form of a single particle.

### Evaluation Example 2: Evaluation of Active Material

Pellet density (PD) of the positive electrode active materials of Examples and Comparative Examples was measured, and the results are shown in Table 1 below.

**Table 1:**

| Item | Single layer/Double layer | Weight ratio | | | Pellet density (g/cc) |
|---|---|---|---|---|---|
| | | First particle (wt%) | Second particle (wt%) | Third particle (wt%) | |
| Example 1 | Double layer | 35 | 30 | 35 | 2.64 |
| Example 2 | Double layer | 35 | 30*¹ | 35 | 2.75 |
| Comparative Example 1 | Single layer | 30 | 70 | 0 | 2.90 |
| Comparative Example 2 | Single layer | 40 | 60 | 0 | 2.83 |
| Comparative Example 3 | Single layer | 50 | 50 | 0 | 2.77 |
| Comparative Example 4 | Single layer | 60 | 40 | 0 | 2.70 |
| Comparative Example 5 | Single layer | 70 | 30 | 0 | 2.63 |
| Comparative Example 6 | Single layer | 80 | 20 | 0 | 2.56 |
| Comparative Example 7 | Single layer | 90 | 10 | 0 | 2.50 |
| Comparative Example 8 | Single layer | 35 | 30 | 35 | 2.62 |

| | | | | | |
|---|---|---|---|---|---|
| ^{*1)} The second particle in a bimodal form was used. | | | | | |

### Evaluation Example 3: Evaluation of Battery Properties

Characteristics of rechargeable lithium batteries prepared using positive electrode active materials each from Examples and Comparative Examples were evaluated.

For initial charging/discharging, the rechargeable lithium batteries were initially charged at a constant current of 0.2 C and after 10 minutes of rest, discharged up to 3.0 V at a constant current of 0.2 C, and subsequently the average voltage was evaluated. Thereafter, the charging/discharging was repeated 50 times at 45 °C and 1.0 C/1.0 C. Coin cells were additionally prepared and subsequently the batteries were initially charged at a constant current of 0.2 C and after 10 minutes of rest, discharged up to 3.0 V at a constant current of 0.2 C and additionally charged, and subsequently measured at -20 °C for capacity. The results of evaluating the battery properties are shown in Table 2 below.

The weight of the second particle in Table 2 indicates the weight of the second particle with respect to the total weight of the first, second and third particles.

**Table 2:**

| Item | Single layer /Double layer | Weight of second particle (wt%) | Battery properties | | | | | | | |
|---|---|---|---|---|---|---|---|---|---|---|
| | | | Charge at 0.2 C | Discharg e at 0.2 C | Efficiency at 0.2 C (%) | Capacity at -20 °C (mAh/g) | Average voltage (V) | Lifetime at 1 C (%, @50cy) | DCIR, SOC50 (Ω, 0.2 C/1.0 C) | Energy density (Wh/kg) |
| Example 1 | Double layer | 30 | 190.1 | 175.8 | 92.5 | 75 | 3.32 | 98.5 | 15.7 | 577 |
| Example 2 | Double layer | 30*² | 189.8 | 174.1 | 91.8 | 71 | 3.32 | 98.8 | 16.9 | 576 |
| Comparati ve Example 1 | Single layer | 70 | 220.8 | 201.5 | 91.3 | 87 | 3.48 | 97.7 | 9.8 | 701 |
| Comparati ve Example 2 | Single layer | 60 | 213.1 | 195.0 | 91.5 | 82 | 3.44 | 97.7 | 11.5 | 671 |
| Comparati ve Example 3 | Single layer | 50 | 205.4 | 188.6 | 91.8 | 78 | 3.4 | 97.8 | 13.3 | 641 |
| Comparati ve Example 4 | Single layer | 40 | 197.7 | 182.1 | 92.1 | 74 | 3.36 | 97.8 | 15.0 | 608 |
| Comparati ve Example 5 | Single layer | 30 | 190.0 | 175.6 | 92.4 | 69 | 3.32 | 97.9 | 16.8 | 577 |
| Comparati ve Example 6 | Single layer | 20 | 182.2 | 169.1 | 92.8 | 65 | 3.28 | 97.9 | 18.5 | 547 |
| Comparati ve Example 7 | Single layer | 10 | 174.5 | 162.6 | 93.2 | 60 | 3.24 | 98 | 20.3 | 517 |
| Comparati ve Example 8 | Single layer | 30 | 190.0 | 175.6 | 92.4 | 69 | 3.32 | 97.4 | 16.8 | 577 |

| | | | | | | | | | | |
|---|---|---|---|---|---|---|---|---|---|---|
| ^{*2)} The second particle in a bimodal form was used. | | | | | | | | | | |

Referring to Table 2, the rechargeable lithium batteries including the positive electrodes according to Examples 1 and 2 have substantially the same or greater level of efficiency, capacity, lifetime, resistance, and energy density as/than the rechargeable lithium battery including the positive electrode according to Comparative Example 8. That is, the performance of a battery including a double layered positive electrode active material is improved compared to the performance of a battery including only a single layered positive electrode active material, even when the mixing ratio of the first, second, and third particles is the same.

### Evaluation Example 4: Evaluation of Resistance and Bindability

Resistance and bindability were evaluated for rechargeable lithium batteries prepared using positive electrode active materials each from Examples and Comparative Examples, and the results are shown in Table 3 below.

For initial charging/discharging, the rechargeable lithium batteries were initially charged at a constant current of 0.2 C and after 10 minutes of rest, discharged up to 3.0 V at a constant current of 0.2 C, and subsequently the average voltage was evaluated. The rechargeable lithium batteries were discharged at 1.0 C for 1 second at SOC50 at a constant current of 0.2 C and subsequently discharged at a constant current of 0.2 C to calculate direct current internal resistance (DCIR).

The content of the first functional additive and the second functional additive and the ratio of the weight ratio of the second functional additive to the weight ratio of the first functional additive (weight ratio of FAD2/FAD1) was calculated.

**Table 3:**

| Item | Single layer/ Double layer | Content of first functional additive FAD1 in first active material layer (parts by weight/100 parts by weight of first active material layer) | | Content of second functional additive FAD2 in second active material layer (parts by weight/100 parts by weight of second active material layer) | | Weight ratio of FAD2/FAD1 | DCIR, SOC50 (Ω, 0.2 C/1.0 C) |
|---|---|---|---|---|---|---|---|
| | | First binder | First conductive material | Second binder | Second conductive material | | |
| Example 1 | Double layer | 2.0 | 2.0 | 3.0 | 3.0 | 1.5 | 15.7 |
| Example 2 | Double layer | 2.0 | 2.0 | 3.0 | 3.0 | 1.5 | 16.9 |
| Comparative Example 1 | Single layer | 2.0 | 2.0 | - | - | - | 9.8 |
| Comparative Example 2 | Single layer | 2.0 | 2.0 | - | - | - | 11.5 |
| Comparative Example 3 | Single layer | 2.0 | 2.0 | - | - | - | 13.3 |
| Comparative Example 4 | Single layer | 2.0 | 2.0 | - | - | - | 15.0 |
| Comparative Example 5 | Single layer | 2.0 | 2.0 | - | - | - | 16.8 |
| Comparative Example 6 | Single layer | 2.0 | 2.0 | - | - | - | 18.5 |
| Comparative Example 7 | Single layer | 2.0 | 2.0 | - | - | - | 20.3 |
| Comparative Example 8 | Single layer | 2.0 | 2.0 | - | - | - | 16.8 |
| Comparative Example 9 | Double layer | 2.0 | 2.0 | 1.5 | 1.5 | 0.75 | 20.1 |
| Comparative Example 10 | Double layer | 1.2 | 1.2 | 4.0 | 4.0 | 3.25 | 23.4 |

Referring to Table 3, the rechargeable lithium batteries including the positive electrodes according to Examples 1 and 2 have a lower resistance (DCIR) than the rechargeable lithium batteries including the positive electrodes according to Comparative Examples 9 and 10. That is, when the ratio of the weight ratio of the second functional additive to the weight ratio of the first functional additive (weight ratio of FAD2/FAD1) satisfies the ranges targeted by the present disclosure, bindability with a current collector may be increased.

A positive electrode according to the present disclosure includes a first particle and a third particle each having an olivine structure, and may thus have improved economic efficiency and average voltage.

A positive electrode according to the present disclosure includes a second particle having a layered structure, and may thus have an improved capacity and energy density.

A positive electrode according to the present disclosure has a second particle and a first particle mixed and placed in a first active material layer, and may thus allow an electrode plate to be further readily prepared.

A positive electrode according to the present disclosure has a first particle, a second particle, and a third particle mixed in desired or optimal ratio and placed to form a double layer structure, and may thus allow both battery characteristics to be improved and an electrode plate to be readily prepared.

## Claims

1. A positive electrode for a rechargeable lithium battery, the positive electrode comprising:
a current collector;
a first active material layer on the current collector; and
a second active material layer on the first active material layer,
wherein the first active material layer includes a first particle containing an olivine structured compound represented by Formula 1, a second particle containing a layered compound represented by Formula 2, a first conductive material, and a first binder,
the second active material layer includes a third particle containing an olivine structured compound represented by Formula 3, a second conductive material, and a second binder,
the first particle and the third particle are in the form of a single particle,
the first binder and the first conductive material constitute a first functional additive,
the second binder and the second conductive material constitute a second functional additive, and
a ratio of a weight ratio of the second functional additive in the second active material layer to a weight ratio of the first functional additive in the first active material layer is in a range about 1.0 to about 2.6,
Formula 1: Liₐ₁Feₓ₁B1_{y1}PO_{4-c1}
wherein in Formula 1, 0.8<a1≤1.2, 0.95≤x1≤0.999, 0.001≤y1≤0.05, x1+y1=1, and 0≤c1≤0.05 are satisfied, and B1 comprises at least one of Ti and a transition metal having an oxidation number of 4,
Formula 2: Liₐ₂Niₓ₂Co_{y2}B2_{z2}O_{2-c2}
wherein in Formula 2, 0.8<a2≤1.2, 0.9≤x2≤1.05, 0.03≤y2≤0.10, 0.01≤z2≤0.05, and 0≤c2≤0.05 are satisfied, and B2 comprises at least one of Al and Mn, and
Formula 3: Liₐ₃Feₓ₃B3_{y3}PO_{4-c3}
wherein in Formula 3, 0.8<a3≤1.2, 0.95≤x3≤0.999, 0.001≤y3≤0.05, x3+y3=1, and 0≤c3≤0.05 are satisfied, and B3 comprises at least one of Ti and a transition metal having an oxidation number of 4.

2. The positive electrode for a rechargeable lithium battery of claim 1, wherein B2 in Formula 2 is Al,
the second particle is in the form of a single particle, and
the second particle has an average particle diameter (D₅₀) in a range of about 3 µm to about 10 µm.

3. The positive electrode for a rechargeable lithium battery of claim 1, wherein B2 in Formula 2 is Al,
the second particle is in the form of a secondary particle in which a plurality of second primary particles are aggregated, and
the second particle has an average particle diameter (D₅₀) in a range of about 10 µm to about 14 µm.

4. The positive electrode for a rechargeable lithium battery of any one of claims 1 to 3, wherein the first particle comprises at least one first primary particle,
the first primary particles have an average size in a range of about 200 nm to about 300 nm, and
the first particle has an average particle diameter (D₅₀) in a range of about 0.5 µm to about 2.5 µm.

5. The positive electrode for a rechargeable lithium battery of any one of claims 1 to 4, wherein the third particle comprises a plurality of third primary particles,
the third primary particles have an average size in a range of about 200 nm to about 300 nm, and
the third particle has an average particle diameter (D₅₀) in a range of about 0.5 µm to about 2.5 µm.

6. The positive electrode for a rechargeable lithium battery of any one of claims 1 to 5, wherein the second particle is in a bimodal form that comprises a single particle form and a secondary particle form.

7. The positive electrode for a rechargeable lithium battery of any one of claims 1 to 6, wherein the second particle has a smaller BET specific surface area than the first particle.

8. The positive electrode for a rechargeable lithium battery of any one of claims 1 to 7, wherein the first particle comprises a coating layer containing carbon, and
the first particle contains a range of about 1.0 wt% to about 2.0 wt% of carbon.

9. The positive electrode for a rechargeable lithium battery of any one of claims 1 to 8, wherein a thickness ratio of the first active material layer to the second active material layer is in a range of about 3:7 to about 7:3.

10. The positive electrode for a rechargeable lithium battery of any one of claims 1 to 9, wherein with respect to a total weight of the first particle, the second particle, and the third particle included in the first active material layer and the second active material layer,
an amount of the second particle is in a range of about 10 wt% to about 30 wt%.

11. The positive electrode for a rechargeable lithium battery of any one of claims 1 to 9, wherein with respect to a total weight of the first particle, the second particle, and the third particle included in the first active material layer and the second active material layer,
an amount of the second particle is in a range of about 20 wt% to about 30 wt%.

12. The positive electrode for a rechargeable lithium battery of any one of claims 1 to 11, wherein:
the content of the first binder is in a range of about 1.2 parts by weight to about 2.0 parts by weight with respect to 100 parts by weight of the first active material layer, and
the content of the second binder is in a range of about 2.0 parts by weight to about 3.0 parts by weight with respect to 100 parts by weight of the second active material layer.

13. The positive electrode for a rechargeable lithium battery of any one of claims 1 to 12, wherein a ratio of the content of the second binder in the second active material layer to the content of the first binder in the first active material layer is in a range of about 1.0 to about 2.44.

14. The positive electrode for a rechargeable lithium battery of any one of claims 1 to 13, wherein the first particle and the third particle comprise a coating layer containing carbon, and
the first active material layer contains less carbon than the second active material layer.

15. A rechargeable lithium battery comprising the positive electrode according to any one of claims 1 to 14.
